# EUROPÄISCHE PATENTANMELDUNG

(11) **EP 1 921 715 A2**
(43) Veröffentlichungstag der Anmeldung: **14.05.2008**
(21) Anmeldenummer: 07021270.9
(22) Anmeldetag: 31.10.2007
(51) Int. Cl.: H01R 9/26, H01R 13/703

(54) **Reihenklemme, Prüfstecker und Prüfklemmenblock**

(30) Priorität: 07.11.2006 DE 102006052894
(71) Anmelder: Phoenix Contact GmbH & Co. KG, 32825 Blomberg (DE)
(72) Erfinder: Diessel, Thorsten, 32120 Hiddenhausen (DE)
(74) Vertreter: Gesthuysen, von Rohr & Eggert

(57) **Zusammenfassung**

Dargestellt und beschrieben ist eine elektrische Reihenklemme, mit einem Klemmengehäuse (2), mit zwei darin angeordneten Leiteranschlußelementen (4, 5) und mit zwei Strombalken (6, 7), deren ersten Endbereiche (8, 8') jeweils einem Leiteranschlußelement (4, 5) zugeordnet sind und deren zweiten Endbereiche (9, 9') zusammen einen federnden Kontaktbereich (10) zur Aufnahme des Kontaktsteckers (11) eines Prüfsteckers (12) bilden, wobei sich die zweiten Endbereiche (9, 9') im nicht eingesteckten Zustand des Kontaktstekkers (11) im Kontaktbereich (9) kontaktieren, so daß die beiden Leiteranschlußelemente (4, 5) über die beiden Strombalken (6, 7) elektrisch miteinander verbunden sind.

Bei der elektrische Reihenklemme sind dadurch sichere und definierte Kontaktzustände beim Einstecken eines Prüfsteckers in die Prüföffnung gewährleistet, daß die zweiten Endbereiche (9, 9') der beiden Strombalken (6, 7) gegeneinander zurückgebogene federnde Kontaktschenkel (13, 13') aufweisen, die zusammen einen zweiten federnden Kontaktbereich (14) zur Aufnahme des Kontaktsteckers (11) eines Prüfsteckers (12) bilden, daß sich die Kontaktschenkel (13, 13') des zweiten Kontaktbereichs (14) im nicht eingesteckten Zustand eines Kontaktsteckers (11) nicht berühren, so daß der zweite Kontaktbereich (14) offen ist, und daß der zweite Kontaktbereich (14) in Einführrichtung (E) des Kontaktsteckers (11) eines Prüfsteckers (12) vor dem ersten Kontaktbereich (10) angeordnet ist, so daß ein eingesteckter Kontaktstecker (11) zuerst den zweiten Kontaktbereich (14) und erst beim weiteren Einführen den ersten Kontaktbereich (10) kontaktiert.

## Beschreibung

Die Erfindung betrifft eine elektrische Reihenklemme, mit einem Klemmengehäuse, mit mindestens zwei darin angeordneten Leiteranschlußelementen und mit mindestens zwei Strombalken, deren ersten Endbereiche jeweils einem Leiteranschlußelement zugeordnet sind und deren zweiten Endbereiche zusammen einen federnden Kontaktbereich zur Aufnahme des Kontaktstekkers eines Prüfsteckers bilden, wobei sich die zweiten Endbereiche im nicht eingesteckten Zustand des Kontaktsteckers im Kontaktbereich kontaktieren, so daß die beiden Leiteranschlußelemente über die beiden Strombalken elektrisch miteinander verbunden sind.

Daneben betrifft die Erfindung noch einen Prüfstecker zum Einstecken in eine elektrische Reihenklemme, mit einem Isoliergehäuse und einem Kontaktstekker, wobei der Kontaktstecker zwei voneinander durch einen Isoliersteg getrennte, in Längsrichtung des Prüfsteckers hintereinander angeordnete Anschlußkontakte aufweist. Schließlich betrifft die Erfindung auch noch einen Prüfklemmenblock bestehend aus einer Mehrzahl von nebeneinander angeordneten Reihenklemmen und einer Mehrzahl von Prüfsteckern.

Elektrische Reihenklemmen sind seit Jahrzehnten bekannt und werden millionenfach bei der Verdrahtung elektrischer Anlagen und Geräte verwendet. Die Klemmen werden meist auf Tragschienen aufgerastet, welche ihrerseits häufig in einer Mehrzahl in einem Schaltschrank angeordnet sind. Als Leiteranschlußelemente werden in Reihenklemmen überwiegend Schraubklemmen oder Zugfederklemmen verwendet. Das Klemmprinzip bei Zugfederklemmen ist ähnlich dem der Schraubtechnik. Während bei der Schraubklemme eine Zughülse durch die Betätigung der Klemmenschraube den Leiter gegen den Strombalken zieht, wird bei der Zugfederklemme diese Aufgabe von der Zugfeder übernommen. Daneben können aber auch Schneidanschlußklemmen oder Schenkelfederklemmen verwendet werden.

Darüber hinaus lassen sich Elektrische Reihenklemmen nach der Anzahl der vorhandenen Leiteranschlußelemente unterscheiden. Der Grundtyp der Reihenklemme weißt zwei Leiteranschlußelemente auf, die über einen Strombalken miteinander verbunden sind; daneben gibt es aber auch Reihenklemmen mit drei, vier oder mehr Leiteranschlußelementen. Diese Reihenklemmen werden je nach ihrer Bauform Dreileiter- oder Vierleiter-Klemmen sowie Doppelstock- oder Dreistock-Klemmen genannt.

Elektrische Klemmen sind in der Regel Verbindungsklemmen, so daß sie mindestens zwei Leiteranschlußelemente aufweisen, die über eine elektrisch leitende Verbindungsschiene, den Strombalken, elektrisch miteinander verbunden sind. Neben diesem Grundtyp der Reihenklemmen, der häufig auch als Durchgangsklemme bezeichnet wird, gibt es eine Vielzahl von unterschiedlichen Reihenklemmentypen, die speziell den jeweiligen Anwendungsfällen angepaßt sind (vgl. Phoenix Contact Katalog Reihenklemmen CLIP-LINE 2005, Seiten 4 - 10). Als Beispiel seien hier Schutzleiterklemmen, Messertrennklemmen und Installationsklemmen genannt.

In der Schalt-, Meß- und Regeltechnik sind Durchgangsklemmen mit Trennmöglichkeit der Standard. Die bei der elektrischen Reihenklemme realisierte Trennmöglichkeit, d. h. die in dem Strombalken vorgesehene Trennstelle ermöglicht es dabei, unterschiedliche Stecker mit unterschiedlichen Funktionen in das Klemmengehäuse der Reihenklemme einzustecken, die dann an der Trennstelle den Strombalken kontaktieren. Als Stecker können dabei neben einfachen Trennsteckern oder Durchgangsverbindern insbesondere auch Prüfstecker verwendet werden, die spezielle Bauelemente aufweisen können und ein Überprüfen der ordnungsgemäßen Funktion des an die Reihenklemme angeschlossenen Stromkreises ermöglichen.

Da die elektrischen Reihenklemmen in der Regel scheibenförmig ausgebildet sind, werden sie meist mit mehreren anderen elektrischen Reihenklemmen zu einem Reihenklemmenblock zusammengesteckt. In einen solchen Reihenklemmenblock können dann eine der Anzahl der Reihenklemmen entsprechende Anzahl an Prüfsteckern eingesteckt werden.

Aus der 10 2005 025 108 B3 ist eine Vorrichtung zum Testen einer Schutz-, Meß- oder Zähleinrichtung, beispielsweise eines Netzschußrelais einer Hoch-oder Mittelspannungsanlage bekannt, die eine an die elektrische Einrichtung anschließbare Polleiste mit mehreren hintereinander angeordneten Polöffnungen und einen Steckerblock mit einer der Anzahl der Polöffnungen entsprechenden Anzahl von Polzungen aufweist. Ein einzelnes Polleistenmodul der Polleiste besteht dabei aus einem Gehäuse, in dem zwei Kontaktbuchsen für den Anschluß zur Anlage und mit den Kontaktbuchsen verbundene federbelastete Kontaktlaschen angeordnet sind. Die beiden Kontaktlaschen können dabei durch die Polzunge eines Steckers kontaktiert werden, wobei die Polzunge des Steckers zwei Polstege aufweist, die durch einen Isoliersteg voneinander getrennt sind. Der Isoliersteg bildet dabei zusammen mit der korrespondierenden Polöffnung im Polleistenmodul eine Codierung, die sicherstellt, daß nur ein Stecker mit einer bestimmten Polzunge in eine bestimmte Polöffnung einer Polleiste einführbar ist.

Im nicht eingesteckten Zustand des Steckers bzw. der Polzunge in die Polleiste kontaktieren die beiden Kontaktlaschen einander, so daß die beiden Kontaktbuchsen elektrisch leitend miteinander verbunden sind und über eine angeschlossene Polleiste ein Strom fließen kann. Ist dagegen der Stecker mit seiner Polzunge vollständig in die Polöffnung eingeschoben, so sind die beiden Kontaktlaschen elektrisch voneinander getrennt und der Stromfluß über den Stecker geführt, so daß ein Testvorgang durchgeführt werden kann. In einem Zwischenstadium - beim Einführen der Polzunge des Steckers in die Polöffnung - kommt es bereits zu einer elektrischen Kontaktierung der beiden Polstege mit den beiden Kontaktlaschen, ohne daß die beiden Kontaktlaschen bereits voneinander getrennt sind. Der dabei über den Stecker fließende Strom ist jedoch stark abhängig davon, wie genau die Polzunge des Steckers in die Polöffnung der Polleiste eingeführt wird, wobei bereits ein geringes Verkanten des Steckers dazu führen kann, daß nicht beide Kontaktlaschen gleichzeitig von den beiden Polstegen der Polzunge kontaktiert werden.

Der vorliegenden Erfindung liegt die Aufgabe zugrunde, eine eingangs beschriebene elektrische Reihenklemme zur Verfügung zu stellen, die sichere und definierte Kontaktzustände beim Einstecken eines Prüfsteckers in die Prüföffnung gewährleistet. Darüber hinaus liegt der Erfindung die Aufgabe zugrunde, einen eingangs beschriebenen Prüfstecker zur Verfügung zu stellen, der bei einfachem Aufbau eine erhöhte Flexibilität beim Prüfen von Schalt-und Meßgeräten ermöglicht.

Die erste Aufgabe ist bei der eingangs beschriebenen elektrischen Reihenklemme dadurch gelöst, daß die zweiten Endbereichen der beiden Strombalken gegeneinander zurückgebogene federnde Kontaktschenkel aufweisen, die zusammen einen zweiten federnden Kontaktbereich zur Aufnahme des Kontaktsteckers eines Prüfsteckers bilden, wobei sich die Kontaktschenkel des zweiten Kontaktbereichs im nicht eingesteckten Zustand des Kontaktsteckers nicht berühren, so daß der zweite Kontaktbereich offen ist, und wobei der zweite Kontaktbereich in Einführrichtung des Kontaktsteckers vor dem ersten Kontaktbereich angeordnet ist, so daß ein eingestecker Kontaktstecker zuerst den zweiten Kontaktbereich und erst beim weiteren Einführen den ersten Kontaktbereich kontaktiert.

Durch die Ausbildung eines definierten zweiten Kontaktbereichs, der in Einführrichtung des Kontaktsteckers vor dem ersten Kontaktbereich angeordnet ist, wird gewährleistet, daß es beim Einführen des Kontaktsteckers durch die Prüföffnung im Klemmengehäuse der elektrischen Reihenklemme zunächst zu einer sicheren elektrischen Verbindung zwischen dem Kontaktstecker und den beiden Strombalken kommt, bevor der erste Kontaktbereich beim weiteren Einführen des Kontaktsteckers geöffnet wird, d. h. die beiden Strombalken elektrisch voneinander getrennt werden.

Erfindungsgemäß sind dabei sowohl der erste Kontaktbereich als auch der zweite Kontaktbereich als federnde Kontaktbereiche ausgebildet, wodurch auf einfache Art und Weise die erforderliche Kontaktkraft eingestellt werden kann. Während der erste Kontaktbereich dabei als Öffner ausgebildet ist, entspricht der zweite Kontaktbereich einem Schließer, d. h. im nicht eingesteckten Zustand des Prüfsteckers sind die beiden Kontaktschenkel des zweiten Kontaktbereichs voneinander getrennt.

Gemäß einer bevorzugten Ausgestaltung ist der zweite Kontaktbereich besonders einfach dadurch realisiert, daß die Kontaktschenkel der zweiten Endbereiche der beiden Strombalken im wesentlichen V-förmig zurückgebogen sind. Hierdurch kann auf einfache Art und Weise der Abstand zwischen den beiden Kontaktschenkeln auf die Breite des Kontaktsteckers eines Prüfstekkers eingestellt werden, so daß es beim Einstecken des Kontaktsteckers zu einem sicheren elektrischen Kontakt zwischen dem Kontaktstecker und den beiden Kontaktschenkeln kommt. Außerdem ist durch eine derartige Ausgestaltung der Kontaktschenkel der zweiten Endbereiche gewährleistet, daß sich der Abstand zwischen den beiden Kontaktschenkeln in Einführrichtung des Kontaktsteckers verringert, so daß die beiden Kontaktschenkel eine Art Einführtrichter für den Kontaktstecker bilden. Zur weiteren Erleichterung des Einführens des Kontaktsteckers in die elektrische Reihenklemme ist vorzugsweise vorgesehen, daß die freien Enden der Kontaktschenkel der zweiten Endbereiche abgerundet oder nach außen abgebogen sind. Hierdurch wird ein Verkanten der Spitze des Kontaktsteckers an den freien Enden der Kontaktschenkel beim Einführen sicher verhindert.

Gemäß einer weiteren vorteilhaften Ausgestaltung der elektrischen Reihenklemme stützen sich die zweiten Endbereiche der beiden Strombalken zwischen dem ersten Kontaktbereich und dem zweiten Kontaktbereich jeweils an einer Gehäuseinnenwand des Klemmengehäuses ab. Hierdurch wird verhindert, daß es beim Einführen des Kontaktsteckers in den zweiten Kontaktbereich aufgrund der federnden Eigenschaft der zweiten Endbereiche zu einem ungewollten Öffnen des ersten Kontaktbereichs kommt. Dadurch, daß sich die zweiten Endbereiche der beiden Strombalken im Bereich des zweiten Kontaktbereichs jeweils an einer Gehäuseinnenwand abstützen, wird die Auslenkung der zweiten Endbereiche auf die zurückgebogenen federnden Kontaktschenkel begrenzt.

Die Realisierung der beiden Strombalken mit den beiden Endbereichen kann durch Ausstanzen und anschließendes Abbiegen eines länglichen Metallstreifens erfolgen. Vorzugsweise ist jedoch vorgesehen, daß die beiden Strombalken jeweils aus zwei einzelnen länglichen Metallstreifen bestehen, die miteinander elektrische leitend verbunden, insbesondere miteinander verschweißt oder verlötet sind. Der erste Endbereich eines Strombalkens ist dabei von dem ersten Metallstreifen und der zweite Endbereich des Strombalkens von dem zweiten Metallstreifen gebildet sein. Dies vereinfacht zum einen die Herstellung der beiden Strombalken, schafft zum anderen die Möglichkeit, für die beiden Endbereiche unterschiedliche optimierte Materialien oder unterschiedliche optimierte Querschnitte zu verwenden, die entsprechend der von dem jeweiligen Endbereich benötigten Steifigkeit und Federeigenschaft ausgebildet sind.

Bei dem eingangs beschriebenen Prüfstecker ist die zuvor genannte Aufgabe dadurch gelöst, daß der erste Anschlußkontakt über einen ersten Strombalkenabschnitt elektrisch leitend mit einem Leiteranschlußelement verbunden ist, daß der zweite Anschlußkontakt mit einem zweiten Strombalkenabschnitt verbunden ist, der mindestens zwei Öffnungen aufweist, und daß im Isoliergehäuse mindestens zwei Brückenschächte zum Einstecken mindestens zweier Steckbrücken korrespondierend zu den Öffnungen im zweiten Strombalkenabschnitt angeordnet sind. Durch die Ausbildung von mindestens zwei Öffnungen im zweiten Strombalkenabschnitt ist eine erhöhte Variabilität beim Brücken mehrerer Prüfstecker gegeben, so daß mit einem Prüfstecker unterschiedliche Prüf- und Testvorgänge durchgeführt werden können.

Da der erfindungsgemäße Prüfstecker häufig zusammen mit weiteren Prüfsteckern zu einem gemeinsamen Prüfsteckerblock verbunden wird oder mehrere Prüfstecker einzeln in mehrere nebeneinander angeordnete elektrische Reihenklemmen eingesteckt werden, ist es wichtig, daß zwischen benachbarten Prüfsteckern, insbesondere zwischen den einzelnen Kontaktsteckern, eine ausreichende Isolierung gewährleistet ist. Dies ist gemäß einer bevorzugten Ausgestaltung des erfindungsgemäßen Prüfsteckers dadurch auf einfache Art und Weise realisiert, daß das Isoliergehäuse mindestens einen Isolierabschnitt aufweist, der in Längsrichtung des Prüfsteckers gesehen parallel zum Kontaktstecker verläuft und im wesentlichen dieselbe Länge wie der Kontaktstekker aufweist. Weisen alle nebeneinander angeordneten Prüfstecker einen solchen Isolierabschnitt auf, so ist es ausreichend, wenn jeder Prüfstecker nur einen Isolierabschnitt aufweist. Hierdurch kann eine besonders schmale Bauform des Prüfsteckers realisiert werden.

Zur sicheren Fixierung bzw. Befestigung des Prüfsteckers an einer elektrischen Reihenklemme weist das Isoliergehäuse vorzugsweise mindestens einen Rastzapfen auf, der in eine entsprechend ausgebildete Rastausnehmung im Klemmengehäuse der elektrischen Reihenklemme einrasten kann und dadurch eine sichere mechanische Verbindung zwischen dem Prüfstecker und der Reihenklemme gewährleistet. Darüber hinaus kann an dem Isoliergehäuse des Prüfsteckers auch ein Codierelement ausgebildet sein, welches zusammen mit einem entsprechenden Gegencodierelement am Klemmengehäuse der Reihenklemme das Aufstecken eines "falschen" Prüfsteckers auf eine bestimmte Reihenklemme verhindert. Das Codierelement kann dabei vorzugsweise als Codiersteg oder Codierzapfen ausgebildet sein, der in eine korrespondierende Codiernut im Klemmengehäuse der Reihenklemme einsteckbar ist.

Elektrische Reihenklemmen, die in der Regel scheibenförmig ausgebildet sind, werden häufig mit mehreren anderen elektrischen Reihenklemmen zu einem Reihenklemmenblock zusammengesteckt und auf eine Tragschiene aufgerastet. Entsprechend werden auch die einzelnen Prüfstecker, die in ihrer Breite in der Regel der Breite der Reihenklemmen entsprechen, zu einem Prüfsteckerblock verbunden und gemeinsam auf einen korrespondierenden Reihenklemmenblock aufgesetzt. Hierbei besteht die Anforderung, daß die Anzahl der miteinander verbundenen Reihenklemmen sowie die Anzahl der miteinander zu einem Prüfsteckerblock zusammengefaßten Prüfstecker frei wählbar ist. Gleichzeitig sollen jedoch die zu einem Prüfsteckerblock zusammengefaßten Prüfstecker möglichst einfach gemeinsam betätigt, d. h. gemeinsam auf den Reihenklemmenblock aufgesteckt werden können.

Diese Aufgabe ist bei einem Prüfklemmenblock bestehend aus einer Mehrzahl von nebeneinander angeordneten Reihenklemmen und einer Mehrzahl von Prüfsteckern, die auf die einzelnen Reihenklemmen aufsteckbar sind, dadurch gelöst, daß auf beiden Seiten der Mehrzahl von nebeneinander angeordneten Reihenklemmen je eine Befestigungsklemme angeordnet ist, die ein Klemmengehäuse mit mindestens einer Befestigungsvorrichtung aufweist, und daß auf beiden Seiten der Mehrzahl von nebeneinander angeordneten Prüfsteckern je ein Befestigungselement angeordnet ist, daß eine zur Befestigungsvorrichtung der Befestigungsklemme korrespondierende Befestigungseinrichtung aufweist, so daß die Mehrzahl von Prüfsteckern über das Befestigungselement mechanisch mit den Befestigungsklemmen - und damit auch mit den Reihenklemmen selber - verbindbar sind.

Durch die Verwendung von zwei Befestigungsklemmen und zwei Befestigungselementen, die jeweils auf beiden Seiten des Reihenklemmenblocks bzw. des Prüfsteckerblocks angeordnet sind, ist die Anzahl der Reihenklemmen sowie die Anzahl der Prüfstecker, die zu einem Reihenklemmenblock bzw. einem Prüfsteckerblock zusammengefaßt werden können, frei wählbar.

Gemäß einer bevorzugten Ausgestaltung weisen beide Befestigungselemente jeweils einen Führungssteg als Befestigungseinrichtung und die beiden Befestigungsklemmen jeweils eine korrespondierende Führungsnut als Befestigungsvorrichtung auf. Wesentlich ist dabei, daß durch die Ausbildung des Führungsstegs und der korrespondierenden Führungsnut ein senkrechtes Einstecken der Kontaktstecker der Prüfstecker zwischen die beiden Strombalken der elektrischen Reihenklemmen, d. h. in die Kontaktbereiche der Reihenklemmen sichergestellt ist, und es somit nicht zu einer Beschädigung der Kontaktstecker oder zu einem Verkanten beim Einstecken kommen kann. Hierzu ist vorgesehen, daß die Führungsstege der Befestigungselemente länger als die Kontaktstecker der Prüfstecker sind, so daß zunächst die Enden der Führungsstege in die Führungsnuten eintauchen, bevor die Enden der Kontaktstecker in die Öffnungen in den Reihenklemmen eingeführt werden und mit den Strombalken in Berührung kommen.

Außer zur Führung der Kontaktstecker beim Einstecken der Prüfstecker in die Reihenklemmen können die Befestigungselemente auch zur Codierung oder zur mechanischen Befestigung des Prüfsteckerblocks an dem Reihenklemmenblock dienen, wozu die Befestigungselemente entsprechende Codierelemente oder Rastelemente aufweisen und in den Befestigungsklemmen korrespondierende Codiernuten oder Rastnuten ausgebildet sind.

Gemäß einer weiteren bevorzugten Ausgestaltung, die hier noch kurz erwähnt werden soll, sind die beiden Befestigungselemente über ein Griffstück miteinander verbunden, so daß der Prüfsteckerblock zusammen mit den beiden Befestigungselementen einfach und bequem mit Hilfe des Griffstückes in den Reihenklemmenblock und die beiden Befestigungsklemmen einsteckbar ist. Das Griffstück ist dabei vorzugsweise am oberen Ende der Befestigungselemente angeordnet, wobei die Befestigungselemente eine größere Höhle als die Prüfstecker aufweisen, so daß das Griffstück die zwischen den beiden Befestigungselementen angeordneten Prüfstecker überspannt.

Sowohl die einzelnen Reihenklemmen als auch die einzelnen Prüfstecker sind vorzugsweise untereinander mechanisch verbindbar, wozu jeweils entsprechende Rastzapfen und Rastausnehmungen in den Klemmengehäusen bzw. in den Isoliergehäusen ausgebildet sind. Zusätzlich sind auch die beiden Befestigungselemente mit den Prüfsteckern und die beiden Befestigungsklemmen mit den Reihenklemmen mechanisch verbindbar, wozu ebenfalls entsprechende Rastzapfen und Rastausnehmungen an den Befestigungselementen und in der Seitenwand der Isoliergehäuse der Prüfstecker bzw. an den Befestigungsklemmen und in der Seitenwand der Klemmengehäuse der Reihenklemmen ausgebildet sind.

Im einzelnen gibt es nun eine Vielzahl von Möglichkeiten, die erfindungsgemäße elektrische Reihenklemme, den erfindungsgemäßen Prüfstecker und den erfindungsgemäßen Prüfklemmenblock auszugestalten und weiterzubilden. Dazu wird verwiesen sowohl auf die den Patentansprüchen 1, 8 und 13 nachgeordneten Patentansprüchen, als auch auf die nachfolgende Beschreibung eines bevorzugten Ausführungsbeispiels in Verbindung mit der Zeichnung. In der Zeichnung zeigen
- Fig. 1: eine erfindungsgemäße Reihenklemme und einen erfindungsgemäßen Prüfstecker, im noch nicht eingesteckten Zustand,
- Fig. 2: die Reihenklemme gemäß Fig. 1, mit teilweise eingestecktem Prüfstecker,
- Fig. 3: die Reihenklemme gemäß Fig. 1, mit vollständig eingestecktem Prüfstecker,
- Fig. 4: einen erfindungsgemäßen Prüfklemmenblock, mit einer Mehrzahl von Reihenklemmen, zwei Befestigungsklemmen, einer Mehrzahl von Prüfsteckern und zwei Befestigungselementen, im noch nicht eingesteckten Zustand der Prüfstecker,
- Fig. 5: den Prüfklemmenblock gemäß Fig. 4, im vollständig eingesteckten Zustand der Prüfstecker, und

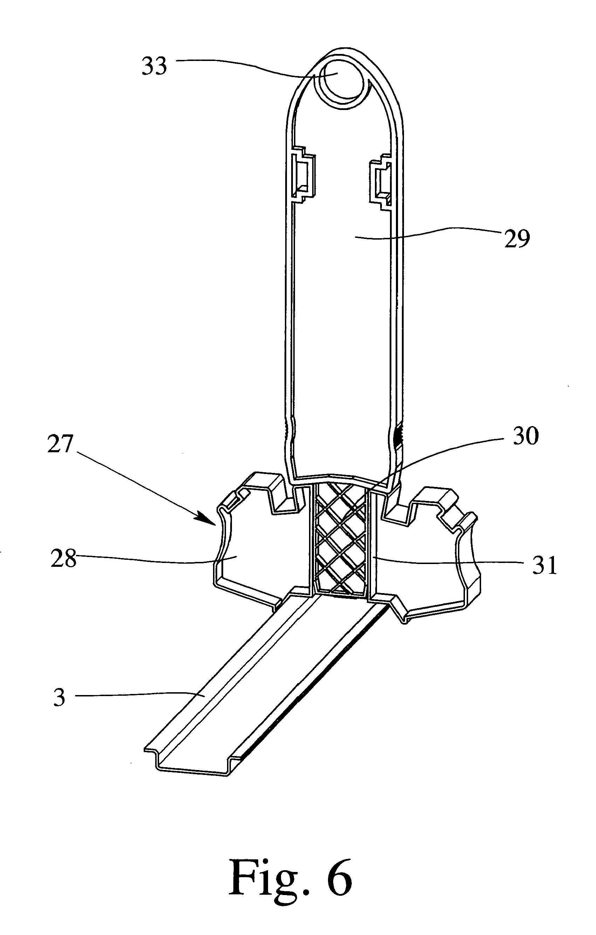

- Fig. 6: eine Befestigungsklemme und ein Befestigungselement eines Prüfklemmenblocks gemäß den Fig. 4 und 5.

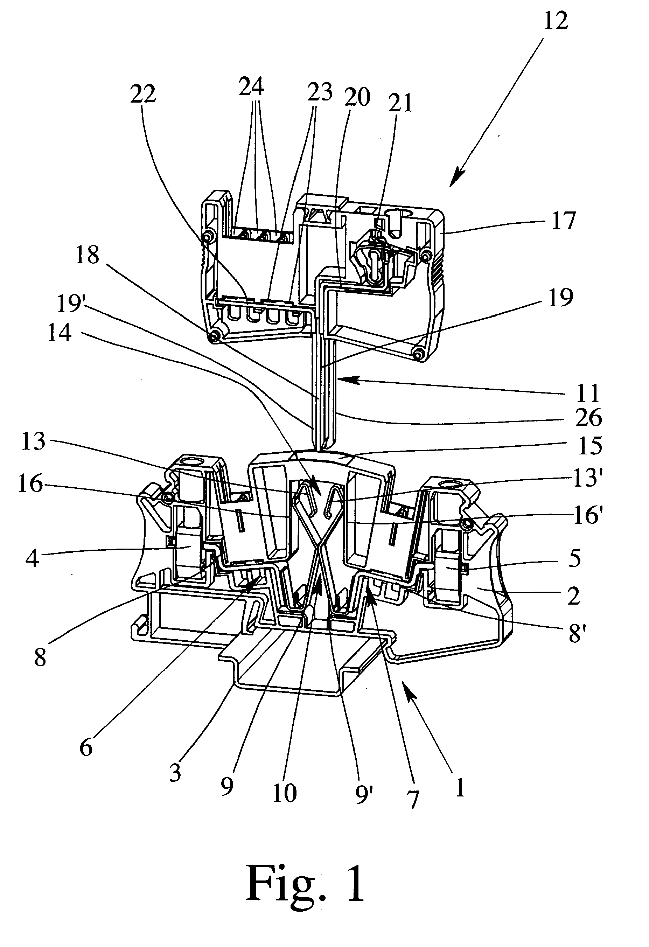

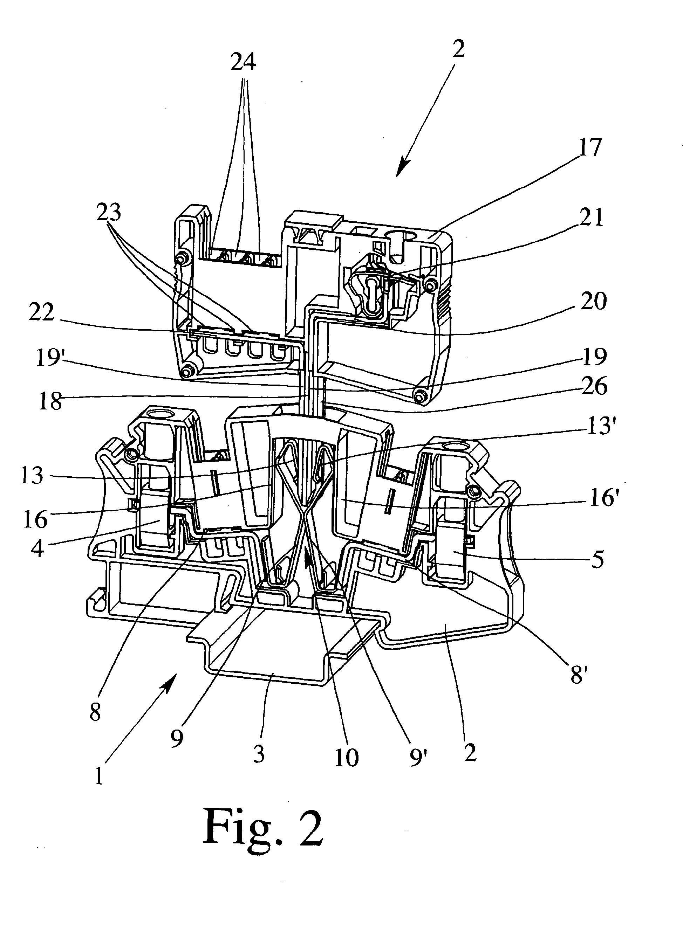

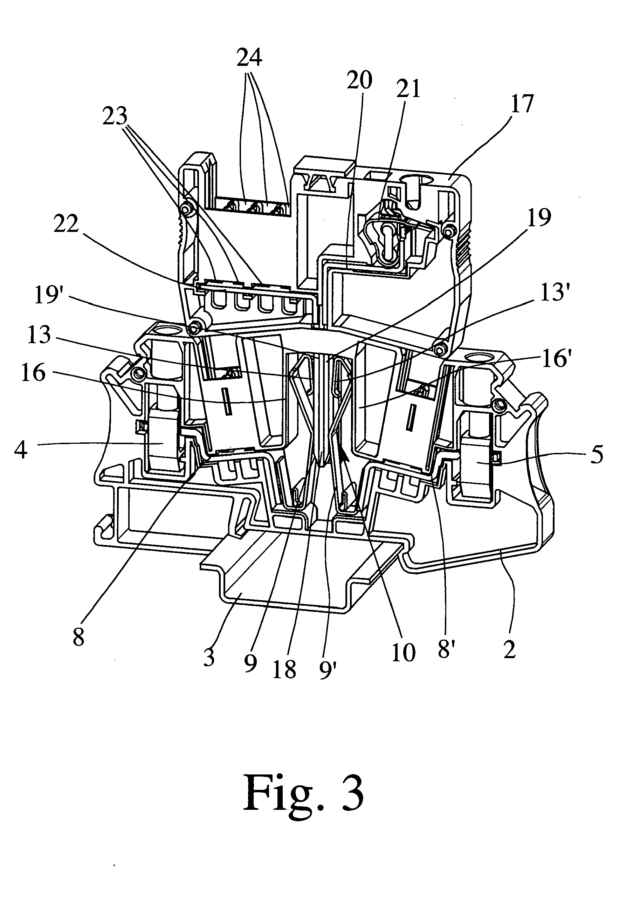

Die Fig. 1 bis 3 zeigen jeweils eine elektrische Reihenklemme 1 und einen Prüfstecker 12, wobei sich der Prüfstecker 12 in der Darstellung gemäß Fig. 1 im noch nicht eingesteckten Zustand, in der Darstellung gemäß Fig. 2 im teilweise eingesteckten Zustand und in der Darstellung gemäß Fig. 3 im vollständig eingesteckten Zustand befindet.

Die elektrische Reihenklemme 1 weist ein Klemmengehäuse 2 auf, das in den dargestellten Ausfiihrungsbeispielen auf einer Tragschiene 3 aufgerastet ist. Im Inneren des Klemmengehäuses 2 sind zwei Leiteranschlußelemente 4, 5 angeordnet, wobei es sich bei den dargestellten Leiteranschlußelemente 4, 5 um Schraubklemmen handelt. Ebenso gut können jedoch auch Zugfederklemmen, Schneidanschlußklemmen oder Schenkelfederklemmen als Leiteranschlußelemente verwendet werden. Neben den Leiteranschlußelementen 4, 5 sind in dem Klemmengehäuse 2 zwei gleich ausgebildete Strombalken 6, 7 angeordnet. Der jeweils erste Endbereich 8, 8' der beiden Strombalken 6, 7 ist jeweils einem der beiden Leiteranschlußelemente 4, 5 zugeordnet, d. h. in die Schraubklemme eingeführt, während die beiden zweiten Endbereiche 9, 9' zusammen einen ersten federnden Kontaktbereich 10 zur Aufnahme des Kontaktsteckers 11 des Prüfsteckers 12 bilden.

Der von den zweiten Endbereichen 9, 9' der beiden Strombalken 6, 7 gemeinsam gebildete erste Kontaktbereich 10 ist dabei derart ausgebildet, daß sich die beiden zweiten Endbereiche 9, 9' gegenseitig kontaktieren, wenn der Kontaktstecker 11 nicht in der elektrischen Reihenklemme 1 eingesteckt ist. In dem in Fig. 1 dargestellten Zustand des Prüfsteckers 12 sind somit die beiden Leiteranschlußelemente 4, 5 über die beiden Strombalken 6, 7 elektrisch miteinander verbunden, d. h. der erste Kontaktbereich 10 ist geschlossen.

Die zweiten Endbereiche 9, 9' der beiden Strombalken 6, 7 weisen außerdem noch jeweils einen zurückgebogenen federnden Kontaktschenkel 13, 13' auf, wobei die beiden Kontaktschenkel 13, 13' zusammen einen zweiten federnden Kontaktbereich 14 zur Aufnahme des Kontaktsteckers 11 des Prüfsteckers 12 bilden. Wie aus Fig. 1 ersichtlich ist, sind die Kontaktschenkel 13, 13' derart angeordnet und abgebogen, daß sie sich im nicht eingesteckten Zustand eines Kontaktsteckers 11 nicht berühren, so daß der zweite Kontaktbereich 14 - im Unterschied zum ersten Kontaktbereich 10 - offen ist.

Da der zweite Kontaktbereich 14 in Einführrichtung des Kontaktsteckers 11 vor dem ersten Kontaktbereich 10 angeordnet ist, erfolgt beim Einstecken des Kontaktsteckers 11 zuerst eine Kontaktierung des zweiten Kontaktbereichs 14 (Fig. 2) und erst beim weiteren Einführen eine Kontaktierung des ersten Kontaktbereichs 10 (Fig. 3). Dabei ist aus den Fig. 1 bis 3 ersichtlich, daß in der Oberseite des Klemmengehäuses 2 eine Öffnung 15 für den Kontaktstecker 11 ausgebildet ist, die symmetrisch zum ersten Kontaktbereich 10 und zum zweiten Kontaktbereich 14 angeordnet ist. Im übrigen ist auch ersichtlich, daß der zweite Kontaktbereich 14 und der erste Kontaktbereich 10 zueinander fluchten angeordnet sind.

Insbesondere aus Fig. 1 ist ersichtlich, daß die Kontaktschenkel 13, 13' der zweiten Endbereiche 9, 9' im wesentlichen V-förmig zurückgebogen sind, und daß die freien Enden der Kontaktschenkel 13, 13' nach außen abgebogen sind. Dadurch entsteht eine Art Einführtrichter für den einzusteckenden Kontaktstecker 11, wodurch das Einstecken erleichtert wird. Um sicherzustellen, daß beim Einstecken des Kontaktsteckers 11 in den zweiten Kontaktbereich 14 nur die Kontaktschenkel 13, 13' und nicht der gesamte zweite Endbereich 9, 9' der Strombalken 6, 7 ausgelenkt wird, stützen sich die zweiten Endbereiche 9, 9' zwischen dem ersten Kontaktbereich 10 und dem zweiten Kontaktbereich 14 jeweils an einer Gehäuseinnenwand 16, 16' des Klemmengehäuses 2 ab. Der Abschnitt der zweiten Endbereiche 9, 9', der sich an den Gehäuseinnenwänden 16, 16' abstützt, bildet dabei den Anfang der V-förmig zurückgebogenen Kontaktschenkel 13, 13'. Dadurch wird verhindert, daß es beim Einstecken des Kontaktsteckers 11 in den zweiten Kontaktbereich 14 zu einem Öffnen des ersten Kontaktbereichs 10 kommt. Insgesamt sind die zweiten Endbereiche 9, 9' der beiden Strombalken 6, 7 zusammen näherungsweise X-förmig ausgebildet, wobei sich am oberen Ende die beiden V-förmig zurückgebogenen Kontaktschenkel 13, 13' anschließen.

Bei dem in den Figuren dargestellten Ausführungsbeispiel der elektrischen Reihenklemme 1 bestehen die beiden Strombalken 6, 7 jeweils aus zwei einzelnen länglichen Metallstreifen, die im Übergangsbereich miteinander verlötet oder verschweißt sind. Die beiden ersten Endbereiche 8, 8' werden dabei jeweils von einem ersten Metallstreifen und die beiden zweiten Endbereiche 9, 9' jeweils von einem zweiten Metallstreifen gebildet. Durch die Verwendung unterschiedlicher Materialien für die beiden Metallstreifen und insbesondere dadurch, daß die beiden Metallstreifen unterschiedliche Querschnitte aufweisen, können der erste Endbereich 8, 8' bzw. der zweite Endbereich 9, 9' besonders einfach mit unterschiedlichen Federeigenschaften ausgebildet werden, so daß der erste Endbereich 8, 8' und der zweite Endbereich 9, 9' jeweils seinen Anforderungen entsprechend dimensioniert werden kann.

Der in den Figuren dargestellte Prüfstecker 12 weist ein Isoliergehäuse 17 auf, aus dem der Kontaktstecker 11 auf einer Seite herausragt. Der Kontaktstecker 11 besteht aus zwei voneinander durch einen Isoliersteg 18 getrennten Anschlußkontakte 19, 19', die in Längsrichtung des Prüfsteckers 12 hintereinander angeordnet sind. Dadurch ist ein Auftrennen des ersten Kontaktbereichs 10 beim vollständigen Einstecken des Kontaktsteckers 11 und damit eine Unterbrechung der leitenden Verbindung zwischen den beiden Leiteranschlußelementen 4, 5 möglich.

Der erste Anschlußkontakt 19 des Kontaktsteckers 11 ist über einen ersten Strombalkenabschnitt 20 elektrisch leitend mit einem Leiteranschlußelement 21, im vorliegenden Fall mit einer Zugfederklemme, verbunden, während der zweite Anschlußkontakt 19' mit einem zweiten Strombalkenabschnitt 22 verbunden ist, der insgesamt vier Öffnungen 23 aufweist. Korrespondierend zu den Öffnungen 23 sind im Isoliergehäuse 17 vier Brückenschächte 24 zum Einstecken von insgesamt vier Steckbrücken 25 angeordnet. Wie aus den Figuren ersichtlich ist, sind sowohl der erste Anschlußkontakt 19 und der erste Strombalkenabschnitt 20 als auch der zweite Anschlußkontakt 19' und der zweite Strombalkenabschnitt 22 jeweils einstückig ausgebildet.

Darüber hinaus kann den Fig. 1 bis 3 noch entnommen werden, daß das Isoliergehäuse 17 einen Isolierabschnitt 26 aufweist, der in Längsrichtung 12 des Prüfsteckers 12 gesehen parallel zum Kontaktstecker 11 verläuft und im wesentlichen dieselbe Länge wie der Kontaktstecker 11 aufweist. Der Isolierabschnitt 26 dient dabei zur Gewährleistung einer ausreichenden Isolierung zwischen den beiden Kontaktsteckern 11 zweier benachbarter zueinander angeordneter Prüfstecker 12.

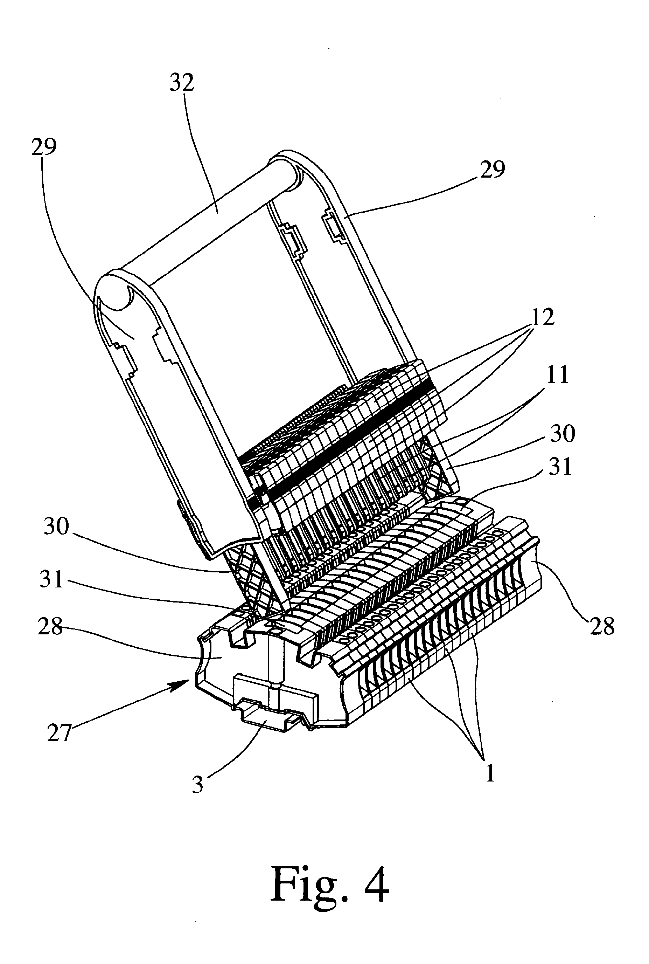

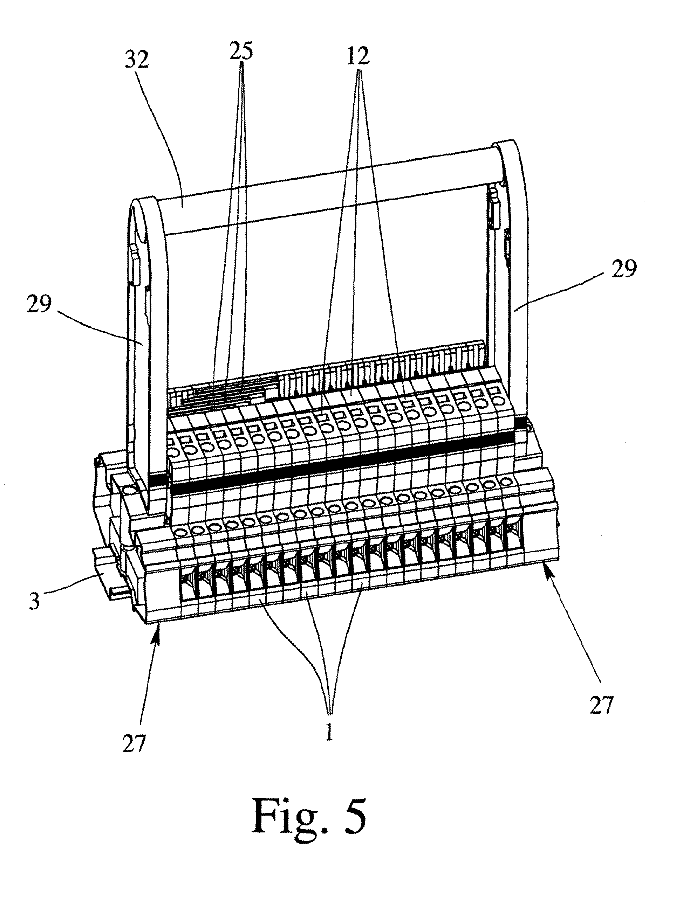

Die Fig. 4 und 5 zeigen einen Prüfklemmenblock bestehend aus einer Mehrzahl von zu einem Reihenklemmenblock miteinander verbundener Reihenklemmen 1 und einer entsprechenden Anzahl von zu einem Prüfsteckerblock zusammengesteckten Prüfsteckern 12. Die Fig. 4 zeigt dabei den Prüfsteckerblock im noch nicht eingesteckten Zustand, während bei der Darstellung gemäß Fig. 5 die einzelnen Prüfstecker 12 auf die einzelnen Reihenklemmen 1 aufgesteckt sind. Auf beiden Seiten der Mehrzahl des Reihenklemmenblocks ist jeweils eine Befestigungsklemme 27 angeordnet, die ein Klemmengehäuse 28 mit einer Befestigungsvorrichtung aufweist. Ebenso ist auf beiden Seiten des Prüfsteckerblocks je ein Befestigungselement 29 angeordnet, das eine zur Befestigungsvorrichtung korrespondierende Befestigungseinrichtung aufweist.

Im dargestellten Ausführungsbeispiel weisen die beiden Befestigungselemente 29 jeweils einen Führungssteg 30 auf, der jeweils in eine im Klemmengehäuse 28 der beiden Befestigungsklemmen 27 ausgebildete Führungsnut 31 einsteckbar ist. Dabei ist ersichtlich, daß die Führungsstege 30 der Befestigungselemente 29 länger als die Kontaktstecker 11 der Prüfstecker 12 sind, wodurch gewährleistet ist, daß zunächst die Enden der Führungsstege 30 in die Führungsnuten 31 eintauchen, bevor die Enden der Kontaktstecker 11 in die Öffnungen 15 in den Reihenklemmen 1 eingeführt werden. Hierdurch wird ein senkrechtes Einstecken der Kontaktstecker 11 zwischen die Strombalken 6, 7 der einzelnen Reihenklemmen 1 sichergestellt, so daß es nicht zu einer Beschädigung der relativ dünnen Kontaktstecker 11 oder zu einem Verkanten beim Einstecken kommen kann.

Zur einfachen Handhabung des aus den einzelnen Prüfsteckern 12 zusammengesetzten Prüfsteckerblocks sind die beiden Befestigungselemente 29 über ein Griffstück 32 miteinander verbunden, wobei das Griffstück 32 mit seinen beiden Enden in korrespondierende Öffnungen 33 am oberen Ende der Befestigungselemente 29 eingreift. Dadurch, daß die Befestigungselemente 29 mehr als doppelt so hoch wie die Prüfstecker 12 sind, wird eine Betätigung der Prüfstecker 12, insbesondere das Stecken oder Ziehen von Steckbrücken 25 durch das die Prüfstecker 12 überspannende Griffstück 32 nicht behindert.

Im Unterschied zu der Ausführung der einzelnen Prüfstecker 12 gemäß Fig. 4 - bei der die Kontaktstecker 11 aller Prüfstecker 12 dieselbe Länge haben - können die einzelnen benachbarten Prüfstecker 12 auch Kontaktstecker 11 mit unterschiedlicher Länge aufweisen. Das Aufstecken der Prüfstecker 12 auf die elektrischen Reihenklemmen 1 erfolgt dann in folgenden Schritten:
- Einführen der Führungsstege 30 der Befestigungselemente 29 in die in den Befestigungsklemmen 27 ausgebildeten Führungsnuten 31.
- Eintauchen der längeren Kontaktstecker 11 einzelner Prüfstecker 12 in die Öffnungen 15 im Klemmengehäuse 2 und Kontaktierung des zweiten Kontaktbereichs 14, wobei die beiden Anschlußkontakte 19, 19' jeweils einen der beiden Kontaktschenkel 13', 13 elektrisch leitend kontaktieren.
- Öffnen des ersten Kontaktbereichs 10 durch die längeren Kontaktstekker 11, wodurch die elektrisch leitende Verbindung der beiden Leiteranschlußelemente 4, 5 über die beiden Strombalken 6, 7 unterbrochen wird.
- Eintauchen der kürzeren Kontaktstecker 11 einzelner Prüfstecker 12 in die Öffnungen 15 im Klemmengehäuse 2 und Kontaktierung des zweiten Kontaktbereichs 14.
- Öffnen des ersten Kontaktbereichs 10 durch die kürzeren Kontaktstekker 11, wodurch die elektrisch leitende Verbindung der beiden Leiteranschlußelemente 4, 5 unterbrochen wird.

Selbstverständlich ist es auch möglich, daß die einzelnen Kontaktstecker 11 der Prüfstecker 12 mehr als zwei unterschiedliche Längen aufweisen, so daß beispielsweise besonders kurze Kontaktstecker 11 auch im vollständig eingesteckten Zustand des Prüfsteckerblocks nur den zweiten Kontaktbereich 14, nicht jedoch auch den ersten Kontaktbereich 10 kontaktieren.

## Patentansprüche

1. Elektrische Reihenklemme, mit einem Klemmengehäuse (2), mit mindestens zwei darin angeordneten Leiteranschlußelementen (4, 5) und mit mindestens zwei Strombalken (6, 7), deren ersten Endbereiche (8, 8') jeweils einem Leiteranschlußelement (4, 5) zugeordnet sind und deren zweiten Endbereiche (9, 9') zusammen einen federnden Kontaktbereich (10) zur Aufnahme des Kontaktsteckers (11) eines Prüfsteckers (12) bilden, wobei sich die zweiten Endbereiche (9, 9') im nicht eingesteckten Zustand des Kontaktsteckers (11) im Kontaktbereich (9) kontaktieren, so daß die beiden Leiteranschlußelemente (4, 5) über die beiden Strombalken (6, 7) elektrisch miteinander verbunden sind,
**dadurch gekennzeichnet,**
**daß** die zweiten Endbereiche (9, 9') der beiden Strombalken (6, 7) gegeneinander zurückgebogene federnde Kontaktschenkel (13, 13') aufweisen, die zusammen einen zweiten federnden Kontaktbereich (14) zur Aufnahme des Kontaktsteckers (11) eines Prüfsteckers (12) bilden,
**daß** sich die Kontaktschenkel (13, 13') des zweiten Kontaktbereichs (14) im nicht eingesteckten Zustand eines Kontaktsteckers (11) nicht berühren, so daß der zweite Kontaktbereich (14) offen ist, und
**daß** der zweite Kontaktbereich (14) in Einführrichtung (E) des Kontaktsteckers (11) eines Prüfsteckers (12) vor dem ersten Kontaktbereich (10) angeordnet ist, so daß ein eingesteckter Kontaktstecker (11) zuerst den zweiten Kontaktbereich (14) und erst beim weiteren Einführen den ersten Kontaktbereich (10) kontaktiert.

2. Elektrische Reihenklemme nach Anspruch 1, **dadurch gekennzeichnet, daß** die Kontaktschenkel (13, 13') der zweiten Endbereiche (9, 9') der beiden Strombalken (6, 7) im wesentlichen V-förmig zurückgebogenen sind.

3. Elektrische Reihenklemme nach Anspruch 2, **dadurch gekennzeichnet, daß** die freien Enden der Kontaktschenkel (13, 13') der zweiten Endbereiche (9, 9') abgerundet oder nach außen abgebogen sind.

4. Elektrische Reihenklemme nach Anspruch 2 oder 3, **dadurch gekennzeichnet, daß** sich die zweiten Endbereiche (9, 9') der beiden Strombalken (6, 7) zwischen dem ersten Kontaktbereich (10) und dem zweiten Kontaktbereich (14) jeweils an einer Gehäuseinnenwand (16, 16') des Klemmengehäuses (2) abstützen.

5. Elektrische Reihenklemme nach einem der Ansprüche 1 bis 4, **dadurch gekennzeichnet, daß** die beiden Strombalken (6, 7) jeweils aus zwei einzelnen länglichen Metallstreifen bestehen, die miteinander elektrisch leitend verbunden sind, insbesondere miteinander verschweißt sind, wobei die beiden ersten Endbereiche (8, 8') jeweils von einem ersten Metallstreifen und die beiden zweiten Endbereiche (9, 9') jeweils von einem zweiten Metallstreifen gebildet werden.

6. Elektrische Reihenklemme nach Anspruch 5, **dadurch gekennzeichnet, daß** die beiden Metallstreifen der beiden Strombalken (6, 7) jeweils aus unterschiedlichem Material bestehen, insbesondere aus Material mit unterschiedlicher Steifigkeit und unterschiedlichen Federeigenschaften.

7. Elektrische Reihenklemme nach Anspruch 5, **dadurch gekennzeichnet, daß** die beiden Metallstreifen der beiden Strombalken (6, 7) jeweils unterschiedliche Querschnitte aufweisen.

8. Prüfstecker zum Einstecken in eine elektrische Reihenklemme (1), insbesondere nach einem der Ansprüche 1 bis 7, mit einem Isoliergehäuse (17) und mit einem Kontaktstecker (11), wobei der Kontaktstecker (11) zwei voneinander durch einen Isoliersteg (18) getrennte, in Längsrichtung des Prüfsteckers (12) hintereinander angeordnete Anschlußkontakte (19, 19') aufweist,
**dadurch gekennzeichnet,**
**daß** der erste Anschlußkontakt (19) über einen ersten Strombalkenabschnitt (20) elektrisch leitend mit einem Leiteranschlußelement (21) verbunden ist,
**daß** der zweite Anschlußkontakt (19') mit einem zweiten Strombalkenabschnitt (22) verbunden ist, der mindestens zwei Öffnungen (23) aufweist, und
**daß** im Isoliergehäuse (17) mindestens zwei Brückenschächte (24) zum Einstecken mindestens zweier Steckbrücken (25) korrespondierend zu den Öffnungen (23) angeordnet sind.

9. Prüfstecker nach Anspruch 8, **dadurch gekennzeichnet, daß** das Isoliergehäuse (17) mindestens einen Isolierabschnitt (26) aufweist, der in Längsrichtung des Prüfsteckers (12) gesehen parallel zum Kontaktstecker (11) verläuft und im wesentlichen dieselbe Länge wie der Kontaktstecker (11) aufweist.

10. Prüfstecker nach Anspruch 8 oder 9, **dadurch gekennzeichnet, daß** das Isoliergehäuse (17) mindestens einen Rastzapfen zur mechanischen Verbindung mit der elektrischen Reihenklemme (1) aufweist.

11. Prüfstecker nach einem der Ansprüche 8 bis 10, **dadurch gekennzeichnet, daß** das Isoliergehäuse (17) mindestens einen Codierelement zum Einstecken in eine korrespondierende Codiernut im Klemmengehäuse (2) der elektrischen Reihenklemme (1) aufweist.

12. Prüfstecker nach einem der Ansprüche 8 bis 11, **dadurch gekennzeichnet, daß** der erste Anschlußkontakt (19) und der erste Strombalkenabschnitt (20) und/oder der zweite Anschlußkontakt (19') und der zweite Strombalkenabschnitt (22) jeweils einstückig ausgebildet sind.

13. Prüfklemmenblock bestehend aus einer Mehrzahl von nebeneinander angeordneten Reihenklemmen (1) nach einem der Ansprühe 1 bis 7 und einer Mehrzahl von Prüfsteckern (12) nach einem der Ansprühe 8 bis 12, wobei die einzelnen Prüfstecker (12) auf die einzelnen Reihenklemmen (1) aufsteckbar sind,
**dadurch gekennzeichnet,**
**daß** auf beiden Seiten der Mehrzahl von nebeneinander angeordneten Reihenklemmen (1) je eine Befestigungsklemme (27) angeordnet ist, die ein Klemmengehäuse (28) mit mindestens einer Befestigungsvorrichtung aufweist, und
**daß** auf beiden Seiten der Mehrzahl von nebeneinander angeordneten Prüfsteckern (12) je ein Befestigungselement (29) angeordnet ist, das eine zur Befestigungsvorrichtung korrespondierende Befestigungseinrichtung aufweist,
so daß die Mehrzahl von Prüfsteckern (12) über das Befestigungselement (29) mechanisch mit den Befestigungsklemmen (27) verbindbar sind.

14. Prüfklemmenblock nach Anspruch 13, **dadurch gekennzeichnet, daß** die Befestigungselemente (29) jeweils einen Führungssteg (30) und die Befestigungsklemmen (27) jeweils eine korrespondierende Führungsnut (31) aufweist, in die die Führungsstege (30) einsteckbar sind.

15. Prüflclemmenblock nach Anspruch 14, **dadurch gekennzeichnet, daß** die Führungsstege (30) der Befestigungselemente (29) länger als die Kontaktstekker (11) der Prüfstecker (12) sind.

16. Prüfklemmenblock nach einem der Ansprüche 13 bis 15, **dadurch gekennzeichnet, daß** die beiden Befestigungselemente (29) über ein Griffstück (32) miteinander verbunden sind, wobei die Befestigungselemente (29) ein größere Höhe (H) als die Prüfstecker (12) aufweisen und das Griffstück (32) am oberen Ende der Befestigungselemente (29) angeordnet ist, so daß das Griffstück (32) die zwischen den beiden Befestigungselementen (29) angeordneten Prüfstecker (12) überspannt.

17. Prüfklemmenblock nach Anspruch 16, **dadurch gekennzeichnet, daß** die Höhe (H) der Befestigungselemente (29) mindestens doppelt so groß wie die Höhe (h) des Prüfsteckers (12) ist.

18. Prüfklemmenblock nach einem der Ansprüche 13 bis 17, **dadurch gekennzeichnet, daß** die beiden Befestigungselemente (29) mechanisch mit den Prüfsteckern (12) verbindbar sind, insbesondere mittels an den Befestigungselementen (29) angeordneter Rastzapfen und in der Seitenwand der Isoliergehäuse (17) der Prüfstecker (12) ausgebildeter Rastausnehmungen.

19. Prüfklemmenblock nach einem der Ansprüche 13 bis 18, **dadurch gekennzeichnet, daß** die beiden Befestigungsklemme (27) mechanisch mit den Reihenklemmen (1) verbindbar sind, insbesondere mittels an den Befestigungsklemmen (27) angeordneter Rastzapfen oder Rastausnehmungen und in der Seitenwand der Klemmengehäuse (2) der Reihenklemmen (1) ausgebildeter Rastausnehmungen oder Rastzapfen.

20. Prüfklemmenblock nach einem der Ansprüche 13 bis 19, **dadurch gekennzeichnet, daß** die beiden Befestigungselemente (29) jeweils mindestens einen Codierelement und die Befestigungsklemmen (27) jeweils eine korrespondierende Codiernut aufweist, in die die Codierelemente einsteckbar sind.

21. Prüfklemmenblock nach einem der Ansprüche 13 bis 19, **dadurch gekennzeichnet, daß** die Kontaktstecker (11) der einzelnen Prüfstecker (12) eine unterschiedliche Länge aufweisen.
